# FASCICULE DE BREVET EUROPEEN

(11) **EP 3 390 272 B1**
(45) Date de publication et mention de la délivrance du brevet: **13.09.2023**
(21) Numéro de dépôt: 16778854.6
(22) Date de dépôt: 11.10.2016
(51) Int. Cl.: B81C 1/00, B22F 7/08, C22C 1/04, C22C 33/02, G04D 7/12, G04B 13/02, G04B 15/14, G04B 17/06, G04B 45/00, B22F 10/10, B22F 10/28

(54) **PROCÉDÉ DE FABRICATION D'UNE PIÈCE D'HORLOGERIE COMPOSITE**
VERFAHREN ZUR HERSTELLUNG EINES KOMPOSIT-UHRENBAUTEILS
METHOD OF MANUFACTURING A COMPOSITE PART FOR WATCHES

(30) Priorité: 15.12.2015 EP 15200204
(43) Date de publication de la demande: 24.10.2018
(73) Titulaire: CSEM Centre Suisse d'Electronique et de Microtechnique SA - Recherche et Développement, 2002 Neuchâtel (CH)
(72) Inventeur: LANI, Sébastien, 1784 Courtepin (CH); PUGIN, Raphaël, 2013 Colombier (CH)
(74) Mandataire: P&TS SA (AG, Ltd.)
(86) Numéro de dépôt international: PCT/EP2016/074316
(87) Numéro de publication internationale: WO 2016/203063

(56) Documents cités:
- EP-A1- 1 172 714
- EP-A1- 2 104 005
- Mohammad Vaezi ET AL: "Multiple material additive manufacturing - Part 1: a review", Virtual and physical prototyping, vol. 8, no. 1, 1 March 2013 (2013-03-01), pages 19-50, XP055657016, UK ISSN: 1745-2759, DOI: 10.1080/17452759.2013.778175
- N.N.: "Hybrid LENS CNC Machine", , 3 May 2015 (2015-05-03), XP055657026, Retrieved from the Internet: URL:https://www.optomec.com/wp-content/upl oads/2015/04/CNCMachine3May2015.pdf [retrieved on 2020-01-10]

## Description

### Domaine technique

La présente invention concerne un procédé de fabrication d'une pièce d'horlogerie et/ou d'un ensemble de pièces d'horlogerie.

Plus particulièrement, la présente invention concerne un procédé de fabrication d'une pièce d'horlogerie composite comportant deux parties, une première partie obtenue dans un premier matériau tel que du silicium par exemple, et une seconde partie obtenue dans un second matériau tel qu'un métal par exemple.

### Etat de la technique

Dans le domaine de l'horlogerie, il est bien connu de réaliser des pièces d'horlogerie tels que des spiraux, des roues ou des balanciers par exemple en silicium.

En effet, le silicium présente de nombreux avantages dont sa légèreté, son élasticité, son caractère amagnétique et la possibilité d'être usiné par des techniques de micro-fabrication telles que la technique de gravure ionique réactive profonde DRIE conformément à l'acronyme anglo-saxon « Deep Reactive Ion Etching ».

Toutefois, le silicium présente également plusieurs inconvénients. Le silicium est fragile, cassant, car il ne présente pas de domaine plastique, rendant difficile la fixation d'une roue en silicium sur un axe par exemple. Par ailleurs, la légèreté du silicium, qui est également un avantage, ne permet pas de réaliser complètement en silicium des pièces horlogères qui doivent avoir une inertie ou un balourd suffisant, telles qu'un balancier ou une masse oscillante par exemple.

Afin de remédier à ces inconvénients, on a déjà imaginé des pièces d'horlogeries dites composites ou hybrides comportant une première partie obtenue dans du silicium ou similaire et une seconde partie obtenue dans du métal par exemple. C'est le cas, notamment, des demandes de brevet WO 2008/135817, EP 2 060 534 et EP 2 104 005 par exemple.

Le document EP 1 172 714 A1 décrit également un procédé d'ajustement de la masse d'un balancier de pièce d'horlogerie par projection d'encre localisée au moyen d'un dispositif à jet d'encre. Ce document ne précise pas toutefois la nature des encres employées qui en détermine la capacité d'application et la précision en fonction des matériaux. La distance d'impression d'un système de type inkjet est aussi fortement limitée et peu compatible à une utilisation sur des pièces d'horlogerie intégrées dans un mouvement horloger.

Le document WO 2008/135817 décrit une pièce d'horlogerie comprenant une structure pouvant être réalisée par une technique de micro-fabrication et au moins un élément formé dans ou à la périphérie de la structure et dans un matériau différent de celui de la structure pour modifier les propriétés mécaniques du composant, par exemple servir à augmenter le rapport inertie/masse d'un balancier ou le rapport balourd/masse d'une masse oscillante, ou à absorber localement une partie des contraintes générées par le chassage d'un axe, et rendre ce dernier utilisable dans une application donnée tout en conservant les avantages du matériau utilisé pour réaliser la structure. Plus particulièrement, ce document décrit un procédé de fabrication d'une telle pièce d'horlogerie composite qui est réalisée à partir d'un substrat en silicium oxydé comportant des cavités remplies par électrodéposition.

Ce type de procédé présente néanmoins l'inconvénient de nécessiter une étape de réalisation d'une cavité en silicium pour la réalisation du moule, ce qui grève le coût de fabrication des pièces d'horlogerie. Ainsi, ce type de procédé n'est pas adapté pour la réalisation de prototypes et/ou de petites séries de pièces.

Le document US 2004/0146650 A1 décrit quant à lui un procédé de fabrication de pièces métalliques microstructurées selon lequel des structures en 3 dimensions sont formées par traitement électrochimique de surface d'une pièce suivie d'un dépôt de poudres pressées à chaud sur la pièce pour en réaliser le durcissement. Ce procédé de fabrication par pression isostatique à chaud (en anglais HIP, pour « Hot Isostatic Pressing ») présente l'inconvénient de requérir non seulement un traitement électrochimique préalable des pièces mais également une étape de pression à chaud des poudres déposées pour former les microstructures, qui nécessite non seulement la mise en oeuvre de moules, et qui en outre s'avère extrêmement difficile voire impossible à mettre en oeuvre sur des pièces de silicium en raison de la fragilité de celles-ci.

Le document EP 2 060 534 décrit un procédé de fabrication d'une pièce de micromécanique composite silicium - métal combinant des processus du type DRIE et LIGA, selon l'acronyme germanique "Rôntgen**li**thographie, **G**alvanoformung, **A**bformung" (lithographie, galvanisation, formage). L'invention se rapporte également à une pièce de micromécanique comprenant une couche dans laquelle une partie est en silicium et une autre en métal afin de former une pièce de micromécanique du type composite. Plus particulièrement, le procédé comprend une étape de ciselage sélectif d'une cavité dans une couche supérieure d'un substrat pour définir un motif d'une partie de silicium de la pièce, une étape de sculpture d'une cavité dans une couche intermédiaire du substrat, une étape de croissance d'une couche métallique à partir d'une partie des cavités pour former une partie métallique le long de l'épaisseur du composant, et à éliminer le composant silicium/métal composite micromécanique du substrat. La couche métallique est développée en recouvrant le dessus du substrat par une résine photosensible, puis un procédé de photolithographie de la résine photosensible selon le motif prédéterminé de la partie métallique est exécuté de manière sélective, et la résine photo-structurée du substrat est ensuite retirée.

Ce type de procédé nécessite la réalisation d'une étape de lithographie sur un substrat en silicium comportant des pièces fragiles. Par ailleurs, ce type de procédé comporte un grand nombre d'étapes qui grèvent le coût de fabrication des pièces d'horlogerie, le rendant inadapté pour la réalisation de prototypes et/ou de petites séries de pièces.

Le document EP 2 104 005 décrit un balancier composite formé dans une couche en un matériau à base de silicium et comportant un moyeu relié à une serge par au moins un bras. La serge comporte au moins une partie supplémentaire sensiblement en forme d'anneau crénelé de plus grande densité que ledit matériau à base de silicium permettant d'augmenter l'inertie dudit balancier. L'invention se rapporte également à un procédé de fabrication d'un tel balancier, ledit procédé consistant à se munir d'un substrat en un matériau à base de silicium, à déposer sélectivement au moins une couche de métal sur le substrat pour définir le motif d'au moins une partie en métal dudit balancier, ledit dépôt s'effectuant par couches successives métalliques au moins partiellement sur la surface du substrat, à graver sélectivement au moins une cavité dans le substrat pour définir le motif du balancier comportant ladite au moins une couche de métal et à libérer le balancier du substrat.

Ce type de procédé présente l'inconvénient de ne permettre que la réalisation de pièces en silicium et non en silicium oxydé, connues sous la dénomination Silinvar (marque déposée), permettant une compensation thermique. Par ailleurs, ce type de procédé présente les inconvénients induits par le procédé de lithographie, outre le fait qu'il présente un fort risque de contamination de la chambre de gravure DRIE.

L'un des buts de l'invention est donc de remédier à ces inconvénients en proposant un procédé de fabrication d'une pièce d'horlogerie composite ou hybride, de conception simple et peu onéreuse, ne comportant pas d'étape de lithographie, permettant la réalisation de prototypes et de petites séries à des faibles coûts et présentant une durée de fabrication réduite par rapport à un procédé de type LIGA notamment.

### Divulguation de l'invention

De façon plus précise, l'invention concerne un procédé de fabrication d'une pièce d'horlogerie comprenant au moins une première partie réalisée par un procédé de micro fabrication ou de micro formage dans au moins un premier matériau, ledit procédé comprenant au moins :
a. une étape de dépôt sur ladite première partie sans moulage d'au moins une deuxième partie de ladite pièce dans au moins un deuxième matériau et
b. une étape de traitement du second matériau pour en lier entre eux les composants sur la première partie.
Selon l'invention ceci comporte au moins les étapes suivantes de
- nébulisation d'une encre sous forme de solution ou de suspension de particules micrométriques, submicroniques ou préférentiellement nanométriques d'au moins un second matériau,
- projection de l'encre nébulisée sur la première partie de la pièce pour former ladite seconde partie, et
- durcissement de ladite seconde partie comprenant un traitement thermique qui comporte au moins une étape de recuit et/ou une étape de frittage localisé ou une polymérisation par photo-réticulation et/ou une réticulation chimique
   ou au moins les étapes suivantes de
- dépôt d'une poudre d'au moins un second matériau sur la première partie de la pièce pour former la seconde partie, et,
- frittage localisé par laser sur ladite seconde partie.

On comprend bien que, contrairement aux procédés de l'art antérieur, le procédé suivant l'invention ne nécessite pas d'étape de lithographie préalablement au dépôt du second matériau, ni de moule pour la pièce ajoutée, ni d'étape d'assemblage, limitant ainsi le coût de fabrication et permettant la réalisation de prototypes et/ou de petites séries à un coût faible. Le procédé de l'invention est en outre particulièrement économe en énergie et respectueux de la pièce sur laquelle le second matériau est déposé, sans moulage, donc sans sollicitation mécanique excessive de ladite pièce et de son premier matériau, ce qui rend sa mise en oeuvre adaptée pour le dépôt sur des pièces fragiles de silicium par exemple.

Le premier procédé correspond au procédé dit AJP selon l'acronyme anglo-saxon « Aérosol Jet Printing » qui permet de déposer un très grand nombre de matériaux, des matériaux conducteurs aux matériaux diélectriques en passant par les matériaux semi-conducteurs ou biologiques, à l'échelle micrométrique sur des pièces planes mais aussi flexibles et tridimensionnelles.

De préférence, l'étape de frittage localisé est obtenue par irradiation de la seconde partie au moyen d'un laser.

Par ailleurs, l'étape de polymérisation par photo-réticulation pourra être obtenue par la projection d'ultra violets sur la seconde partie.

Le second procédé correspond au procédé dit LS ou SLS selon l'acronyme anglo-saxon « Laser Sintering » ou « Selective Laser Sintering » respectivement qui permet l'utilisation d'une très large palette de poudres de différents matériaux dont des polymères, tels que le polyétheréthercétone (PEEK) et les nylons PA12 éventuellement associés à de la fibre de verre, à des billes de verre ou encore à de la poudre d'aluminium, et/ou des métaux tels que l'acier, le titane, l'or, etc. et leurs alliages.

Ladite deuxième partie forme soit une structure décorative soit une structure de marquage soit un élément fonctionnel, tel qu'une masse inertielle ou un élément dit d'interfaçage ou un organe destiné à avoir une fonction mécanique de coopération avec une autre pièce.

Par ailleurs, la première partie de la pièce est obtenue dans du silicium et/ou du métal et/ou de la céramique et/ou du plastique.

De plus, la seconde partie de la pièce peut comporter une couche ou une pluralité de couches, chaque couche étant obtenue dans un matériau.

De préférence, la seconde partie de la pièce, ou chaque couche de ladite seconde partie, est obtenue dans un matériau comprenant de l'argent (Ag) et/ou de l'aluminium (Al) et/ou de l'or (Au) et/ou du titane (Ti) et/ou du cuivre (Cu) et/ou du nickel (Ni) et/ou du platine (Pt) et/ou du fer (Fe) et/ou un de leurs oxydes et/ou au moins un polymère.

Le procédé selon l'invention permet d'obtenir une pièce d'horlogerie comprenant au moins une première partie réalisée par un procédé de micro fabrication ou de micro formage dans au moins un premier matériau, remarquable en ce qu'elle comporte au moins une deuxième partie obtenue dans au moins un second matériau poreux et déposée sur tout ou partie de ladite première partie. Ladite pièce d'horlogerie ne fait pas partie de la présente invention. On notera que, en fonction du procédé de fabrication de la deuxième partie selon l'invention, la deuxième partie pourra présenter une microporosité ou une mésoporosité ou une macroporosité.

De préférence, la première partie de la pièce est obtenue dans du silicium et/ou du métal et/ou de la céramique et/ou du plastique.

Par ailleurs, la seconde partie de la pièce peut comporter une couche ou une pluralité de couches, chaque couche étant obtenue dans un matériau.

De préférence, la seconde partie de la pièce, ou chaque couche de ladite seconde partie, est obtenue dans un matériau comprenant de l'argent (Ag) et/ou de l'aluminium (Al) et/ou de l'or (Au) et/ou du titane (Ti) et/ou du cuivre (Cu) et/ou du nickel (Ni) et/ou du platine (Pt) et/ou du fer (Fe) et/ou un de leurs oxydes et/ou au moins un polymère.

De plus, le procédé selon l'invention permet d'obtenir une pièce d'horlogerie comprenant au moins une première partie réalisée par un procédé de micro fabrication ou de micro formage dans au moins un premier matériau, remarquable en ce qu'elle comporte au moins une deuxième partie obtenue dans au moins un second matériau constitué de particules micrométriques, submicroniques ou préférentiellement nanométriques liées entre elles et déposées sur tout ou partie de ladite première partie. Ladite pièce d'horlogerie ne fait pas non plus partie de la présente invention.

De la même manière que précédemment, la première partie de la pièce est obtenue, de préférence, dans du silicium et/ou du métal et/ou de la céramique et/ou du plastique.

Par ailleurs, la seconde partie de la pièce peut comporter une couche ou une pluralité de couches, chaque couche étant obtenue dans un matériau.

De préférence, la seconde partie de la pièce, ou chaque couche de ladite seconde partie, est obtenue dans un matériau comprenant de l'argent (Ag) et/ou de l'aluminium (Al) et/ou de l'or (Au) et/ou du titane (Ti) et/ou du cuivre (Cu) et/ou du nickel (Ni) et/ou du platine (Pt) et/ou du fer (Fe) et/ou un de leurs oxydes et/ou au moins un polymère.

De plus, le procédé selon l'invention permet d'obtenir une pièce d'horlogerie comprenant au moins une première partie réalisée par un procédé de micro fabrication ou de micro formage dans au moins un premier matériau, remarquable en ce qu'elle comporte au moins une deuxième partie obtenue dans au moins un second matériau poreux et déposée en couches successives sur tout ou partie de ladite première partie de telle sorte que ladite seconde partie comporte des flancs formant un angle compris entre 10° et 89° avec la surface sur laquelle elle est déposée. Ladite pièce d'horlogerie ne fait pas non plus partie de la présente invention.

On observera que le dépôt de la seconde partie par couches successives, dans un même matériau ou dans un matériau différent, permet de réaliser une seconde partie avec des flancs inclinés selon un angle compris entre 10° et 89° , contrairement aux procédés de l'art antérieur qui ne permettent la réalisation de pièces dont les flancs sont droits, i.e. présentant un angle de 90° avec la surface de la première partie. De cette manière, il est possible d'améliorer l'aérodynamisme de la pièce d'horlogerie mais également d'optimiser la répartition des masses de ladite pièce.

De la même manière que précédemment, la première partie de la pièce est obtenue, de préférence, dans du silicium et/ou du métal et/ou de la céramique et/ou du plastique.

Par ailleurs, la seconde partie de la pièce peut comporter une couche ou une pluralité de couches, chaque couche étant obtenue dans un matériau.

De préférence, la seconde partie de la pièce, ou chaque couche de ladite seconde partie, est obtenue dans un matériau comprenant de l'argent (Ag) et/ou de l'aluminium (Al) et/ou de l'or (Au) et/ou du titane (Ti) et/ou du cuivre (Cu) et/ou du nickel (Ni) et/ou du platine (Pt) et/ou du fer (Fe) et/ou un de leurs oxydes et/ou au moins un polymère.

### Brève description des dessins

D'autres détails de l'invention apparaîtront plus clairement à la lecture de la description qui suit, faite en référence au dessin annexé dans lequel :
- les figure 1A à 1D sont des représentations schématiques en coupe des différentes étapes du procédé de fabrication d'une pièce d'horlogerie suivant l'invention ;
- la figure 2 est une représentation schématique du mode de réalisation du procédé suivant l'invention par impression du type AJP ;
- la figure 3 est une représentation schématique du mode de réalisation du procédé suivant l'invention par dépôt de type LS ou SLS ;
- la figure 4 est une vue de dessus partielle d'une roue d'échappement comportant un marquage obtenu par le procédé suivant l'invention mais ne faisant pas partie de l'invention.
- la figure 5 est une vue en perspective d'un balancier comportant des plots obtenus selon le procédé suivant l'invention pour corriger son inertie. Le balancier ne fait pas partie de l'invention.

### Mode de réalisation de l'invention

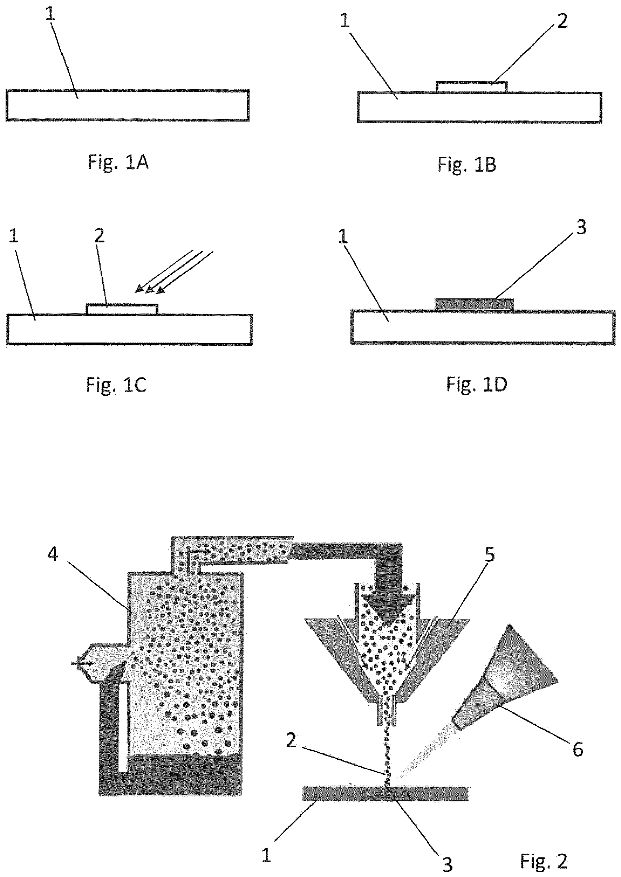

En référence aux figures 1A à 1D, le procédé de fabrication d'une pièce d'horlogerie comprend une première étape de fabrication d'une première partie 1 réalisée par un procédé de micro fabrication ou de micro formage , bien connu de l'homme du métier, en référence à la figure 1A, dans un premier matériau tel que du silicium par exemple. Ledit premier matériau pourra consister dans tout autre matériau tel que, par exemple, du métal, de la céramique, du plastique, du diamant, du quartz, du verre, du carbure de silicium ou une combinaison de ces derniers. Par ailleurs, ladite première partie consiste dans toute pièce d'horlogerie bien connue de l'homme du métier tel qu'une roue d'échappement, un balancier, etc.

Dans une seconde étape, en référence à la figure 1B, un second matériau 2 est déposé sur ladite première partie 1, sur tout ou partie de cette dernière, puis, en référence à la figure 1C, une étape de traitement est réalisée sur le second matériau pour lier entre eux les composants de la seconde partie 3 et lier la seconde partie 3 à la première partie 1, et former une seconde partie 3 poreuse. On notera que, en fonction du type de traitement appliqué pour obtenir le durcissement de seconde partie 3, et détaillé dans la suite du document, les pores de ladite seconde partie 3 pourront présenter un diamètre inférieur à 2 nanomètres (microporosité) ou un diamètre compris entre 2 et 50 nanomètres (mesoporosité) ou un diamètre supérieur à 50 nanomètres (macroporosité). Le second matériau pourra consister dans tout matériau approprié tel qu'un matériau métallique comprenant de l'argent (Ag) et/ou de l'aluminium (Al) et/ou de l'or (Au) et/ou du titane (Ti) et/ou du cuivre (Cu) et/ou du nickel (Ni) et/ou du platine (Pt) et/ou du fer (Fe) et/ou un de leurs oxydes et/ou au moins un polymère par exemple.

Selon un premier mode de réalisation, en référence à la figure 2, le procédé comporte au moins les étapes suivantes de nébulisation d'une encre sous forme de solution ou de suspension de particules micrométriques, submicroniques ou préférentiellement nanométriques d'au moins un second matériau, ladite nébulisation s'effectuant dans une chambre dite de nébulisation 4, puis, au moyen d'une buse 5 connectée à la chambre de nébulisation 4, de projection de l'encre nébulisée sur la première partie 1 de la pièce pour former ladite seconde partie 3, et finalement de durcissement de ladite seconde partie 3 par un traitement thermique dans un four ou par un frittage localisé par un laser 6, tel qu'un laser infrarouge par exemple, sur ladite seconde partie 3. On entend par « durcissement » le processus de liaison directe ou indirecte des particules micrométriques, submicroniques ou nanométriques pour obtenir leur cohésion.

Ce procédé correspond au procédé dit AJP selon l'acronyme anglo-saxon « Aérosol Jet Printing » qui permet de déposer un très grand nombre de matériaux, des matériaux conducteurs aux matériaux diélectriques en passant par les résines, les adhésifs ou les matériaux semi-conducteurs ou biologiques, à l'échelle micrométrique sur des pièces planes mais aussi flexibles et tridimensionnelles.

On observera que l'étape de durcissement par traitement thermique au four ou par un frittage localisé par un laser pourra être substituée par toute autre étape de traitement telle que par polymérisation par exemple. Cette polymérisation consiste en une photo-réticulation qui pourra être obtenue par une projection d'ultra violets sur la seconde partie 3 par exemple, ou en une réticulation chimique sans pour autant sortir du cadre de l'invention.

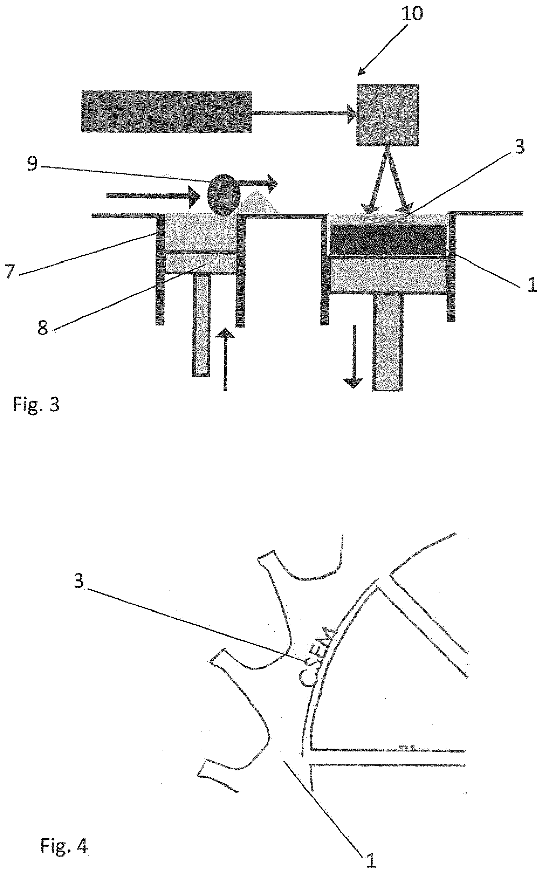

Selon un second mode de réalisation, en référence à la figure 3, le procédé comporte au moins les étapes suivantes de dépôt d'une poudre d'au moins un second matériau sur la première partie 1 de la pièce, ladite poudre initialement contenue dans un réservoir 7 muni d'un piston 8 étant déposée sur la première partie 1 au moyen d'un rouleau 9, et une étape de frittage localisé par un laser de puissance 10 sur ladite seconde partie 3, l'excédent de poudre étant évacué par ledit rouleau 9.

Ce procédé correspond au procédé dit LS ou SLS selon l'acronyme anglo-saxon « Laser Sintering » ou « Selective Laser Sintering » respectivement qui permet l'utilisation d'une très large palette de poudres de différents matériaux dont des polymères, tels que le polyétheréthercétone (PEEK) et les nylons PA12 éventuellement associés à de la fibre de verre, à des billes de verre ou encore à de la poudre d'aluminium, et/ou des métaux tels que l'acier, le titane, l'or, etc. et leurs alliages.

On comprend bien que, contrairement aux procédés de l'art antérieur, le procédé suivant l'invention ne nécessite pas d'étape de lithographie préalablement au dépôt du second matériau, ni de moule pour la pièce ajoutée, ni d'étape d'assemblage, limitant ainsi le coût de fabrication et permettant la réalisation de prototypes et/ou de petites séries à un coût faible.

Par ailleurs, le procédé suivant l'invention permet la réalisation d'une seconde partie 3 par dépôt de couches successives, dans un même matériau ou dans un matériau différent, de telle sorte que ladite seconde partie présente des flancs inclinés selon un angle compris entre 10° et 89° . De cette manière, il est possible d'améliorer l'aérodynamisme de la pièce d'horlogerie mais également d'optimiser la répartition des masses de ladite pièce.

Ladite deuxième partie 3 forme soit une structure décorative soit une structure de marquage soit un élément fonctionnel, tel qu'une masse inertielle ou un élément dit d'interfaçage ou un organe destiné à avoir une fonction mécanique de coopération avec une autre pièce.

Ainsi, le procédé suivant l'invention permet dans une première application d'imprimer un élément de décoration, tel qu'un texte ou un dessin par exemple sur une pièce d'horlogerie en silicium, métal, plastique, céramique (ou tout autre matériau utilisé en horlogerie). Le matériau ajouté est choisi selon sa couleur par rapport au substrat. L'utilisation d'une méthode additive selon l'invention permet d'éviter d'endommager la pièce ou de modifier les performances de la pièce.

En référence à la figure 4, la seconde partie 3 consiste en un élément de décoration se présentant sous la forme de la dénomination CSEM qui est imprimé sur une roue d'échappement formant la première partie 1.

Par ailleurs, la seconde partie 3 peut consister en un élément d'identification tel qu'un numéro de série, un code barre, un hologramme, etc. sur une pièce d'horlogerie en silicium, métal, plastique, céramique (ou tout autre matériau utilisé en horlogerie) à partir du procédé suivant l'invention. De la même manière que précédemment, l'utilisation d'une méthode additive permet d'éviter d'endommager la pièce ou de modifier les performances de cette dernière. Le matériau imprimé est choisi pour son contraste avec la pièce d'horlogerie, par exemple de l'or (Au) pour une identification visible sur une pièce en silicium.

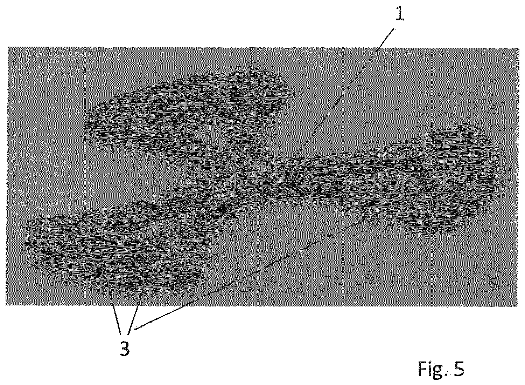

En référence à la figure 5, la deuxième partie 3 peut consister en un élément fonctionnel tel qu'une masse inertielle déposée sur un balancier formant la première partie 1. De cette manière, la deuxième partie 3 permet d'augmenter l'inertie d'une pièce d'horlogerie en silicium, métal, plastique, céramique (ou tout autre matériau utilisé en horlogerie). Le matériau de la seconde partie 3 est choisi par rapport à sa masse volumique, par exemple de l'or (Au) ou du platine (Pt). On notera que le procédé suivant l'invention, et plus particulièrement le procédé AJP précédemment décrit, procure une très bonne précision et une très bonne reproductibilité pour la réalisation de masses. Par exemple sur 8 dépôts identiques, environ 0.33mg ont été déposées avec une déviation standard de 0.03mg correspondant à la résolution de la micro balance utilisée.

De plus, la deuxième partie 3 pourra consister en un élément fonctionnel pour corriger l'inertie d'un balancier, roue ou tout autre pièce d'horlogerie nécessitant une modification de l'inertie en métal, silicium, céramique, plastique ou combinaison de ces matériaux. Ainsi, le ou les secondes parties 3 permettent d'équilibrer un balancier possédant une masse pré définie. Accessoirement, Il est possible d'insérer directement sur la première partie un système de mesure permettant l'équilibrage automatique d'un balancier ou de toute pièce d'horlogerie.

Dans un autre mode de réalisation, la deuxième partie 3 peut former un élément d'interfaçage. Le silicium étant cassant, un élément d'interfaçage peut être imprimé sur une pièce en silicium ou dans un matériau ne possédant pas de domaine de déformation plastique. Le matériau d'interfaçage est d'abord déposé sur la pièce formant la première partie 1 à sa surface externe ou bien dans l'axe de chassage, puis on applique un traitement thermique approprié. L'axe est ensuite inséré dans la pièce, seul le métal d'interface subissant une déformation.

Dans un autre mode de réalisation, la seconde partie 3 peut former un organe destiné à avoir une fonction mécanique de coopération avec une autre pièce. Ledit organe pourra consister par exemple en un doigt ou un pignon qui est ajouté selon le procédé sur ladite pièce d'horlogerie.

On observera que l'épaisseur des secondes parties 3, de l'ordre de quelques micromètres à quelques centaines de micromètres pourra être adaptée par l'Homme du métier en fonction de la nature du matériau utilisé pour les secondes parties 3 et l'application choisie (élément décoratif ou fonctionnel) notamment.

Par ailleurs, bien que l'invention ait été décrite pour des pièces d'horlogerie en silicium, elle pourrait être appliquée à tout autre matériaux usinables par des techniques de micro fabrication et/ou micro formage sans pour autant sortir du cadre de l'invention.

## Revendications

1. Procédé de fabrication d'une pièce d'horlogerie comprenant au moins une première partie (1) réalisée par un procédé de micro fabrication ou de micro formage dans au moins un premier matériau, ledit procédé comprenant au moins :
- une étape de dépôt sur ladite première partie (1) sans moulage d'au moins une deuxième partie (3) de ladite pièce dans au moins un deuxième matériau et
- une étape de traitement du deuxième matériau pour en lier entre eux les composants sur la première partie;
**caractérisé en ce qu'**il comporte au moins les étapes suivantes de
- nébulisation d'une encre sous forme de solution ou de suspension de particules micrométriques, submicroniques ou préférentiellement nanométriques d'au moins un second matériau,
- projection de l'encre nébulisée sur la première partie (1) de la pièce pour former ladite seconde partie (3), et
- durcissement de ladite seconde partie (3) comprenant un traitement thermique qui comporte au moins une étape de recuit et/ou une étape de frittage localisé ou une polymérisation par photo-réticulation et/ou une réticulation chimique;
- ou au moins les étapes suivantes de
- dépôt d'une poudre d'au moins un second matériau sur la première partie (1) de la pièce pour former la seconde partie (3), et,
- frittage localisé par laser sur ladite seconde partie (3).

2. Procédé de fabrication selon la revendication 1, **caractérisé en ce que** l'étape de frittage localisé est obtenu par irradiation de la seconde partie au moyen d'un laser.

3. Procédé de fabrication selon la revendication 1, **caractérisé en ce que** l'étape de polymérisation par photo-réticulation est obtenue par la projection d'ultraviolets sur la seconde partie.

4. Procédé de fabrication selon l'une des revendications 1 à 3, **caractérisé en ce que** la deuxième partie (3) forme une structure décorative.

5. Procédé de fabrication selon l'une des revendications 1 à 3, **caractérisé en ce que** la deuxième partie (3) forme une structure de marquage.

6. Procédé de fabrication selon l'une des revendications 1 à 3, **caractérisé en ce que** la deuxième partie (3) forme un élément fonctionnel.

7. Procédé de fabrication selon la revendication 6, **caractérisé en ce que** l'élément fonctionnel est une masse inertielle.

8. Procédé de fabrication selon la revendication 6, **caractérisé en ce que** l'élément fonctionnel est un élément dit d'interfaçage.

9. Procédé de fabrication selon la revendication 6, **caractérisé en ce que** l'élément fonctionnel est un organe destiné à avoir une fonction mécanique de coopération avec une autre pièce.

10. Procédé de fabrication selon l'une quelconque des revendications 1 à 9, **caractérisé en ce que** le matériau qui compose la première partie (1) de la pièce comprend du silicium et/ou du métal et/ou de la céramique et/ou du plastique.

11. Procédé de fabrication selon l'une quelconque des revendications 1 à 10, **caractérisé en ce que** la seconde partie (3) de la pièce comporte une pluralité de couches, chaque couche étant obtenue dans un matériau.

12. Procédé de fabrication selon l'une quelconque des revendications 1 à 11 **caractérisé en ce que** la seconde partie (3) de la pièce (1), ou chaque couche de ladite seconde partie (3), est obtenue dans un matériau comprenant de l'argent (Ag) et/ou de l'aluminium (Al) et/ou de l'or (Au) et/ou du titane (Ti) et/ou du cuivre (Cu) et/ou du nickel (Ni) et/ou du platine (Pt) et/ou du fer (Fe) et/ou un de leurs oxydes et/ou au moins un polymère.

## Patentansprüche

1. Verfahren zur Herstellung eines Uhrenbauteils, umfassend mindestens ein erstes Teil (1), das mit einem Mikrofertigungs- oder Mikroformverfahren aus mindestens einem ersten Material ausgeführt ist, wobei das Verfahren mindestens umfasst:
- einen Schritt des Aufbringens auf das erste Teil (1) ohne Gießen mindestens eines zweiten Teils (3) des Bauteils aus mindestens einem zweiten Material und
- einen Schritt des Behandelns des zweiten Materials, um dessen Komponenten auf dem ersten Teil untereinander zu verbinden;
**dadurch gekennzeichnet, dass** es mindestens die folgenden Schritte umfasst
- Zerstäuben einer Tinte in Form einer Lösung oder Suspension mikrometrischer, submikrometrischer oder bevorzugt nanometrischer Partikel mindestens eines zweiten Materials,
- Sprühen der zerstäubten Tinte auf das erste Teil (1) des Bauteils, um das zweite Teil (3) zu bilden, und
- Härten des zweiten Teils (3), umfassend eine thermische Behandlung, die mindestens einen Schritt des Glühens und/oder einen Schritt des lokalisierten Sinterns oder eine Polymerisation durch Fotovernetzung und/oder eine chemische Vernetzung umfasst;
- oder mindestens die folgenden Schritte
- Aufbringen eines Pulvers mindestens eines zweiten Materials auf das erste Teil (1) des Bauteils, um das zweite Teil (3) zu bilden, und,
- lokalisiertes Lasersintern auf dem zweiten Teil (3) .

2. Herstellungsverfahren nach Anspruch 1, **dadurch gekennzeichnet, dass** der Schritt des lokalisierten Sinterns durch Bestrahlen des zweiten Teils mittels eines Lasers erhalten wird.

3. Herstellungsverfahren nach Anspruch 1, **dadurch gekennzeichnet, dass** der Schritt der Polymerisation durch Fotovernetzung durch das Projizieren von ultraviolettem Licht auf das zweite Teil erhalten wird.

4. Herstellungsverfahren nach einem der Ansprüche 1 bis 3, **dadurch gekennzeichnet, dass** das zweite Teil (3) eine dekorative Struktur bildet.

5. Herstellung nach einem der Ansprüche 1 bis 3, **dadurch gekennzeichnet, dass** das zweite Teil (3) eine Kennzeichnungsstruktur bildet.

6. Herstellungsverfahren nach einem der Ansprüche 1 bis 3, **dadurch gekennzeichnet, dass** das zweite Teil (3) ein funktionelles Element bildet.

7. Herstellungsverfahren nach Anspruch 6, **dadurch gekennzeichnet, dass** das funktionelle Element eine Trägheitsmasse ist.

8. Herstellungsverfahren nach Anspruch 6, **dadurch gekennzeichnet, dass** das funktionelle Element ein sogenanntes Schnittstellenelement ist.

9. Herstellungsverfahren nach Anspruch 6, **dadurch gekennzeichnet, dass** das funktionelle Element ein Organ ist, das dazu bestimmt ist, eine mechanische Funktion des Zusammenwirkens mit einem anderen Bauteil zu haben.

10. Herstellungsverfahren nach einem der Ansprüche 1 bis 9, **dadurch gekennzeichnet, dass** das Material, aus dem das erste Teil (1) des Bauteils besteht, Silicium und/oder Metall und/oder Keramik und/oder Kunststoff umfasst.

11. Herstellungsverfahren nach einem der Ansprüche 1 bis 10, **dadurch gekennzeichnet, dass** das zweite Teil (3) des Bauteils eine Mehrzahl von Schichten umfasst, wobei jede Schicht aus einem Material erhalten wird.

12. Herstellungsverfahren nach einem der Ansprüche 1 bis 11, **dadurch gekennzeichnet, dass** das zweite Teil (3) des Bauteils (1) oder jede Schicht des zweiten Teils (3) aus einem Material erhalten wird, der Silber (Ag) und/oder Aluminium (Al) und/oder Gold (Au) und/oder Titan (Ti) und/oder Kupfer (Cu) und/oder Nickel (Ni) und/oder Platin (Pt) und/oder Eisen (Fe) und/oder eines ihrer Oxide und/oder mindestens ein Polymer umfasst.

## Claims

1. Process for the manufacture of a timepiece comprising at least one first part (1) produced by a microfabrication or microforming process in at least one first material, said process comprising at least:
- a stage of deposition on said first part (1), without moulding, of at least one second part (3) of said piece in at least one second material and
- a stage of treatment of the second material in order to bond together the components thereof on the first part;
**characterized in that** it comprises at least the following stages of
- nebulisation of an ink in the form of a solution or suspension of micrometric, submicronic or preferentially nanometric particles of at least one second material,
- spraying of the nebulised ink over the first part (1) of the piece in order to form said second part (3), and
- curing of said second part (3) comprising a heat treatment which comprises at least a stage of annealing and/or a stage of localised sintering or a polymerisation by photocrosslinking and/or a chemical crosslinking;
- or at least the following stages of
- deposition of a powder of at least one second material on the first part (1) of the piece in order to form the second part (3), and
- localised laser sintering on said second part (3) .

2. Manufacturing process according to Claim 1, **characterized in that** the stage of localised sintering is obtained by irradiation of the second part by means of a laser.

3. Manufacturing process according to Claim 1, **characterized in that** the stage of polymerisation by photocrosslinking is obtained by the projection of ultraviolet rays on the second part.

4. Manufacturing process according to one of Claims 1 to 3, **characterized in that** the second part (3) forms a decorative structure.

5. Manufacturing process according to one of Claims 1 to 3, **characterized in that** the second part (3) forms a marking structure.

6. Manufacturing process according to one of Claims 1 to 3, **characterized in that** the second part (3) forms a functional element.

7. Manufacturing process according to Claim 6, **characterized in that** the functional element is an inertial mass.

8. Manufacturing process according to Claim 6, **characterized in that** the functional element is an "interfacing" element.

9. Manufacturing process according to Claim 6, **characterized in that** the functional element is a device intended to have a mechanical function of interaction with another piece.

10. Manufacturing process according to any one of Claims 1 to 9, **characterized in that** the material which composes the first part (1) of the piece comprises silicon and/or metal and/or ceramic and/or plastic.

11. Manufacturing process according to any one of Claims 1 to 10, **characterized in that** the second part (3) of the piece comprises a plurality of layers, each layer being obtained in one material.

12. Manufacturing process according to any one of Claims 1 to 11, **characterized in that** the second part (3) of the piece (1), or each layer of said second part (3), is obtained in a material comprising silver (Ag) and/or aluminium (Al) and/or gold (Au) and/or titanium (Ti) and/or copper (Cu) and/or nickel (Ni) and/or platinum (Pt) and/or iron (Fe) and/or one of their oxides and/or at least one polymer.
